# EUROPÄISCHE PATENTSCHRIFT

(11) **EP 2 256 508 B1**
(45) Veröffentlichungstag und Bekanntmachung des Hinweises auf die Patenterteilung: **18.07.2018**
(21) Anmeldenummer: 10005093.9
(22) Anmeldetag: 14.05.2010
(51) Int. Cl.: G01R 31/02

(54) **Prüfverfahren und Anordnungen zur Messung von Teilentladungen an einem Einleiterseekabelspleiß**
Test procedure and assemblies for measuring partial discharges in a discharger sea cable splice
Procédé de contrôle et dispositifs destinés à mesurer des décharges partielles sur une épissure de câble sous-marin à conducteur

(30) Priorität: 26.05.2009 DE 102009022705; 28.09.2009 DE 102009043339
(43) Veröffentlichungstag der Anmeldung: 01.12.2010
(73) Patentinhaber: NKT GmbH & Co. KG, 51061 Köln (DE)
(72) Erfinder: Amerpohl, Uwe, 51467 Bergisch Gladbach (DE); Comanns, Rudolf, 41199 Mönchengladbach (DE); Kujat, Swetlana, 40211 Düsseldorf (DE); Haase, Michael, 51381 Leverkusen (DE)
(74) Vertreter: Feder Walter Ebert

(56) Entgegenhaltungen:
- WO-A1-00/42444
- DE-A1- 3 822 288
- DE-A1- 4 009 243
- JP-A- H 085 700

## Beschreibung

Die Erfindung betrifft ein Prüfverfahren und Anordnungen zur Messung von Teilentladungen an einem Spleiß von einadrigen überlangen Seekabeln für Mittel- und Hochspannung.

Zur Absicherung der Produktqualität von kunststoff-isolierten Hochspannungskabeln und den zugehörigen Garnituren (Endverschlüsse, Verbindungsmuffen) ist es üblich, sogenannte Teilentladungs(TE-)Messungen vorzunehmen (vgl. EP 0806 676 A1).

Zur Absteuerung des unstetigen Übergangs zwischen einem Bereich der Hochspannung und den auf Erdpotential liegenden Bereichen in Kabelenden, vorzugsweise in Muffenverbindungen, werden bekanntermaßen aufschiebbare Feldsteuerelemente mit integrierten Feldsteuertrichtern eingesetzt (DE 38 22 288 A1, oder DE 4009 243 A1).

Bei Verbindungsmuffen von Seekabeln, welch letztere Einzelabschnitte von einer Länge von bis zu 30 km haben können, ist schon ein Messverfahren vorgeschlagen worden (WO 00-042444 A1), bei dem eine Teilentladungsmessung von einem Ende des Seekabels vorgenommen wird. Es wird dabei ein hochfrequentes elektrisches Messsignal an einem der im Spleißbereich endenden Kabelleiter angelegt und im Spleißbereich eine Messelektrode aufgebracht. Das Verfahren kommt ohne Feldsteuerelemente im Spleißbereich aus, da der Bereich der Messelektrode und der im Spleißbereich zurückgesetzte Kabelschirm auf Erdpotential gelegt sind und somit kein Potentialsprung vorhanden ist. Der Nachteil dieses Verfahrens liegt darin, dass für betont lange Hochspannungskabel eine extrem hohe elektrische Leistung für das Messsignal eingespeist werden muss, um über die lange Mess-Strecke noch ein ausreichendes Messsignal empfangen zu können. Über eine lange Mess-Strecke steht das Messsignal nur sehr stark gedämpft an oder ist überhaupt nicht mehr zu empfangen. Fehlerhafte Strukturen können daher nur schwer aus einem Messsignal herausgelesen werden.

Es ist die Aufgabe der Erfindung ein Teilentladungs-(TE-)Messverfahren und Anordnungen für das Verfahren anzugeben, welches unmittelbar an einem frisch hergestellten Seekabelspleiß von betont langen Seekabeln vornehmbar ist, wobei allein der Bereich des Seekabelspleiß' lokal untersucht wird.

Die Lösung der Aufgabe wird in den unabhängigen Ansprüchen 1 und 2 formuliert, wobei weiterführende Ausgestaltungen in zugehörigen Unteransprüchen angegeben sind.

Das Verfahren wird vor der endgültigen Herstellung einer im Spleißbereich anzuordnenden Kabelmuffe mit mindestens folgenden Verfahrensschritten auf beiden im Spleiß zusammengefügten Kabelenden vorgenommen:
- Herstellen einer für die Höhe der Mess-Spannung der TE-Messung durchschlagsicheren, leitschichtfreien Isolierstrecke an den Kabelenden - also zwischen Kabelspleiß und Beginn der Leitschicht am Kabelende,
- Übergänge zwischen Isolierstrecke und Leitschicht am Kabelende mit einmalig verwendeten Feldsteuerelementen versehen, und
- Übergänge zwischen Isolierstrecke und mit Leitschicht versehenem Kabelspleiß mit einmalig verwendeten Feldsteuerelementen versehen,
- Feldsteuerelement am Kabelende und Kabelleiter in Kontakt zu Massepotential bringen;
- Leitschicht des Kabelspleiß' mit Mess-Kontakt versehen;
- Teilentladungsmessung ausführen.

Als Feldsteuerelemente sollen erfindungsgemäß drei Typen eingesetzt werden:
- Ein erstes Feldsteuerelement, welches allein aus einem leitfähigen Feldsteuertrichter als Einzelkörper besteht. Dieses Feldsteuerelement kann am Übergang zwischen Isolierstrecke und Leitschicht am Kabelende eingesetzt werden.
- Ein zweites Feldsteuerelement mit integriertem leitfähigem Feldsteuertrichter kann am Übergang zwischen Isolierstrecke und mit äußerer Leitschicht versehenem Kabelspleiß eingesetzt werden.
- Ein drittes Feldsteuerelement: Es ist ein Feldsteuerelement mit eingebetteten, und mit gegeneinander gerichteten Feldsteuertrichtern, das die gesamte Isolierstrecke einschließlich der Übergänge zwischen Isolierstrecke und Leitschicht am Kabelende und der Übergänge zwischen Isolierstrecke und mit äußerer Leitschicht versehenem Kabelspleiß bedeckt.

Die vorgeschlagenen Verfahren hat den unmittelbaren Vorteil, dass direkt am Ort der Verbindungsmuffe (Kabelspleiß) die TE-Messung durchführbar ist. Durch die unmittelbare Überprüfung am Kabelspleiß wird eine hohe Sicherheit für die Qualität eines Spleißes im Seekabelbereich geliefert.

Das Prüfverfahren ist zur Messung der Teilentladungen an vulkanisierten Muffen im Seekabelbereich entwickelt worden. Es kann sowohl im Mittelspannungsbereich als auch im Hochspannungsbereich (> 100 kV) eingesetzt werden.

Im Bereich des Einleiterseekabelspleiß' und dem Ort einer zu legenden Muffe wird die Isolierung im Allgemeinen nach Herstellen der Kabelleiterverbindung über den Kabelleitern durch eine Wicklung isolierender Bänder (aus PE) aufgebracht. Die isolierenden Bänder werden unter erhöhtem Druck und erhöhter Temperatur miteinander verschmolzen und dadurch vernetzt. Auf der Isolierung wird noch eine äußere Leitschicht durch Graphitieren aufgebracht. Durch das manuelle Aufbringen der Bänder und Störungen im Prozess können Verunreinigungen in die Isolierschicht hineingebracht werden oder Anhaftprobleme entstehen, die im Rahmen einer elektrischen Prüfung (TE-Messung) deutlich zu erkennen wären. Die Teilentladungsmessung am Einleiterseekabelspleiß wird nach Herstellung der Isolierung, jedoch vor Fertigstellung der Muffe eingesetzt. Unter Einsatz von Feldsteuerelementen wird lokal im Spleißbereich eine TE-Messung ermöglicht. Erfindungsgemäß werden im Spleißbereich zur Potentialsteuerung bei der Durchführung des Prüfverfahrens Feldsteuerelemente für den Einmalgebrauch als verlorene Elemente eingesetzt. Die TE-Messung kann in mehreren Varianten vorgenommen werden.

Die Übergänge zwischen Isolierstrecke und Leitschicht am Kabelende sind mit einem leitfähigen Feldsteuertrichter (ohne Grundkörper) als Einzelkörper versehen und die Übergänge zwischen Isolierstrecke und mit äußerer Leitschicht versehenem Kabelspleiß sind mit einem Feldsteuerelement mit integrierten Feldsteuertrichter versehen.

Feldsteuertrichter als Einzelkörper sind für dauerhafte Einrichtungen nicht zu gebrauchen, da diese nach dem Einbau durch die weiteren Muffenelemente verformt werden und ihre Trichterform nicht beibehalten. Dadurch geht die Eigenschaft als Feldsteuerelement verloren. Für die erfindungsgemäße Anwendung ergeben sich jedoch hervorragend Vorteile.

Weiterhin wird vorgeschlagen, zur Erzielung der Durchschlagsicherheit die gesamte Isolierstrecke - auf beiden Seiten des Kabelspleiß' - mit einem einstückigen Feldsteuerelement zu bedecken. Das einstückige Feldsteuerelement umfasst sowohl einen leitfähigen Feldsteuertrichter für die Potentialsteuerung am Kabelende als auch einen Feldsteuertrichter für den Übergang zwischen Kabelspleiß und Kabelenden. Die Trichteröffnungen der jeweiligen Feldsteuertrichter sind gegeneinander gerichtet. Mit diesem besonders für die betrachtete Prüfsituation hergestellten Feldsteuerelement lässt sich die Isolierstrecke sehr stark verkürzten, so dass sich Arbeits- und Vorbereitungsaufwand verringert.

Die ausführlichere Darstellung der Anordnung und der Verfahrensschritte wird im Zusammenhang mit den Figuren erläutert.

Die Erfindung und verschiedene Varianten des Prüfverfahrens wird in Zeichnungen dargestellt, welche im Einzelnen darstellen:
Fig. 1: erste Darstellung von Kabelspleiß, Isolierstrecke, Kabelende;
Fig. 1A: ein Detail am Feldsteuertrichter;
Fig. 2: ein zweite Darstellung mit Feldsteuerelementen und
Fig. 3: ein dritte Darstellung mit einstückigen Feldsteuerelementen.

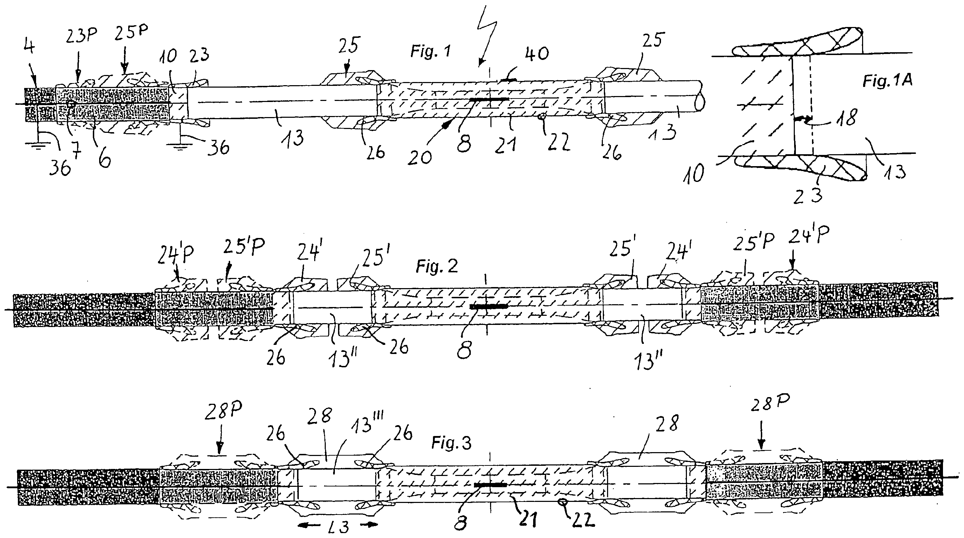

Die Abläufe und Aufeinanderfolge der Verfahrensschritte sind auf beiden im Kabelspieß zusammengeführten Kabelenden gleich, so dass jeweils nur der Ablauf des Verfahrens auf einem Kabelende beschrieben wird. Die Figuren unterscheiden sich in der Verwendung verschiedener Feldsteuerelemente und stellen Varianten des Prüfverfahrens dar. Fig. 1 zeigt eine erste Variante des Prüfverfahrens.

Vor Herstellung des Kabelspleiß' 8,20 wird auf jeder Seite ein leitfähiger Feldsteuertrichter 23 als Einzelkörper für die Potentialsteuerung am Kabelende in eine Park-Position 23P auf das Kabelende gebracht. Der Feldsteuertrichter 23 ist nicht in einem Grundkörper ausgebildet, wie es sonst bei Feldsteuerelementen der Fall ist.

Auf dem unstetigen Übergang am Spleißende muß ebenfalls ein Feldsteuerelement aufgebracht werden. Dieses ist bei der ersten Variante der Erfindung ein Feldsteuerkörper 25 mit integriertem Feldsteuertrichter 26. Am Ort des unstetigen Übergangs am Spleißende kann ein leitfähiger Feldsteuertrichter 23 als Einzelkörper nicht eingesetzt werden, da dort die Hochspannung abgesteuert wird, und ein leitfähiger Feldsteuertrichter 23 als Einzelkörper keine genügende Spannungsfestigkeit liefern würde. Am Übergang zwischen Kabelende und Isolierstrecke sind die elektrischen Feldverhältnisse einfacher, da dieser Bereich - wie noch erwähnt - auf Massepotential gelegt wird.

Sodann wird vor Herstellung des Kabelspleiß' das weitere Feldsteuerelement 25 für das Spleißende ebenfalls in eine Parkposition 25P gebracht. Als nächstes wird eine Isolierung 21 auf der Kabelleiterverbindung 8 hergestellt und die Isolierung 21 mit einer Leitschicht 22 versehen. Die Isolierung ist eine manuell hergestellte Wicklung aus isolierenden Bändern (aus PE), welche unter erhöhtem Druck und erhöhter Temperatur miteinander verschmelzen und dadurch vernetzt werden. Zwischen Kabelspleiß 20 und Kabelende ist danach eine durchschlagsichere, leitschichtfreie Isolierstrecke 13 hergestellt. Im nächsten Schritt werden die Feldsteuerelemente 25 aus ihren Parkpositionen 25P in ihre Endlagen auf den Übergang von Kabelspleiß 20 zum Kabelende 6 geschoben. Die Feldsteuertrichter 23 werden ebenfalls aus ihren Parkpositionen 23P in die Endlage am Kabelende gebracht. Weiter wird auf die äußere Leitschicht 22 des Kabelspleiß' 20 das Hochspannungspotential (Kontakt 40) angelegt. Zur Begrenzung des elektrischen Feldes am Kabelspleiß wird erstens der Einzelleiter 7 des Kabels 4 mit Massepotential 36 verbunden und zweitens der leitfähige Feldsteuertrichter 23 als Einzelköper ebenfalls auf Erdpotential gelegt. Anschließend wird die Teilentladungsmessung durchgeführt.

In Fig. 1A ist ein Detail an einem Feldsteuertrichter 23 dargestellt. Es ist darauf zu achten, dass die Lage des Feldsteuertrichters 23 (aber auch die Lagen der Feldsteuertrichter 26 im Feldsteuerelement 25' oder 28 in Fig. 2 und 3) in bezug auf das Ende der Leitschicht (10 oder 22) mit einem Profilöffnungsabstand 18 eingehalten wird.

Bei der Messung von Teilentladungen (TE-Messung) wird Hochspannungspotential an die äußere Leitschicht im Spleißbereich angelegt. Der Leiter 7 und die gegenüberliegenden Feldsteuerelemente werden auf Erdpotential gelegt. Für die TE-Messung wird üblicherweise ein Trafo, ein Koppelkondensator und zur Erfassung des TE-Signals ein Ankoppelvierpol verwendet. Die Prüfspannung liegt sowohl bei Mittel- als auch bei Hochspannungskabeln beim 1,5-fachen der Nennspannung U₀ (mit steigender Tendenz zum 2-fachen von U₀).

Nach der TE-Messung und Feststellung der Fehlerfreiheit des Kabelspleiß' werden der TE-Mess-Kontakt 40 und die Kontakte zum Massepotential 36 entfernt und die leitschichtfreien Abschnitte 13 (13",13'") mit einer Leitschicht versehen. Die verwendeten Feldsteuertrichter und/oder Feldsteuerelemente werden entfernt. Zum Abschluss der Arbeiten wird eine Außenhülle (beispielsweise ein PE-Mantel oder ein Bleimantel jeweils mit Armierung) auf die Kabelenden und den Kabelspleiß hergestellt und damit die Muffe fertiggestellt.

Fig. 2 zeigt gegenüber Fig. 1 eine Verfahrensvariante. Dort wird statt eines einzelnen Feldsteuertrichters 23 als Einzelkörper zur Potentialsteuerung am Kabelende ein Feldsteuerelement 24' mit eingebettetem Feldsteuertrichter (26) eingesetzt. Die Länge der Isolierstrecke 13" entspricht ungefähr derselben Länge, wie sie in einem Endverschluss eines Kabels für dieselbe Spannungsebene einzurichten wäre. Für eine spezielle Anwendung empfiehlt es sich, hierfür praktische Versuche und Berechnungen vorzunehmen. Als Richtwert kann man für eine Prüfspannung von 170 kV eine Isolierstrecke von ca. 300 mm, und bei einer Prüfspannung von 36 kV eine Isolierstrecke von ca. 100 mm angeben.

Hierbei können herkömmliche, auch für Kabel-Endverschlüsse geeignete Feldsteuerelemente verwendet werden, wie sie bei Kabeln mit entsprechenden Durchmessern und entsprechender Auslegung bezüglich Spannungsebene bekannt sind und eingesetzt werden. Gegenüber der zuvor beschriebenen Ausgestaltung der Erfindung lässt sich die notwendige, durchschlagsfreie Isolierstrecke verkürzen, so dass sich deren erste Länge (von 13) auf eine zweite Länge (hier von 13") verringert.

Der Vorteil zur ersten Variante sind kleinere Absetzmaße, die dazu führen, dass die Reparaturzeit verkürzt wird. (Im Vergleich zur ersten Variante: Reduzierung der Absetzmaße bei einem Bleimantel um ca. 21 % und eine Reduzierung der Absetzmaße bei einem äußeren PE-Mantel um ca. 5 %).

In Fig. 3 ist dargestellt, dass in einer weiteren bevorzugten Verfahrensvariante ein einstückiges, die gesamte Isolierstrecke 13'" bedeckendes Feldsteuerelement 28 mit eingebetteten Feldsteuertrichtern 26 eingesetzt wird. Die eingebetteten Feldsteuertrichter 26 liegen mit ihren Trichteröffnungen gegeneinander gerichtet. Wiederum liegen die Positionen der Feldsteuerelemente relativ zur äußeren Leitschicht wie in einem Endverschluss. Die Länge L3 der Isolierstrecke 13'" ist bereits durch die Länge des besonderen einstückigen Feldsteuerelements 28 vorgegeben

Die Vorteile zu den oben erwähnten Varianten sind die geringere Anzahl der Feldsteuerelemente (statt 4 jetzt nur 2), eine Reduzierung der Länge L3 der Isolierstrecke 13"', was eine Verkleinerung des Feldsteuerelements bedeutet und schlussendlich eine weitere Reduzierung der Absetzmaße

Das Feldsteuerelement 28 umfasst den Feldsteuertrichter 26 für Potentialsteuerung am Kabelende und das Feldsteuerelement 26 für Übergang zwischen Kabelspleiß und Kabelende. Wie zuvor wird vor der Herstellung des Spleißes 20 und der Isolierstrecke 13'" der Länge L3 das einstückige Feldsteuerelement 28 in seine Park-Position 28P auf das Kabelende gebracht. Dieses einstückige Feldsteuerelement enthält gemeinsam alle Potentialsteuerelemente zur Erzielung der Durchschlagsicherheit. Es kann als 'verlorenes' Bauteil hergestellt und verwendet werden, da es nur für den bestimmten Zweck im Rahmen der Erfindung einmalig gebraucht wird.

### Bezugszeichen

- 4, 6: Kabel, Kabelende
- 7: Kabelleiter
- 8: Spleißverbindung Kabelleiter
- 10: Leitschicht Kabel
- 13 13" 13'": Isolierstrecke (leitschichtfreier Abschnitt)
- L3: Länge
- 18: Profilöffnungsabstand unter einem Feldsteuertrichter
- 20: Kabelspleiß
- 21: Isolierung im Speißbereich
- 22: Leitschicht auf Isolierung im Speißbereich (Graphitierung)
- 23: (verlorener) leitfähiger Feldsteuertrichter als Einzelkörper für Kabelende
- 24': (verlorenes) Feldsteuerelement für Kabelende mit eingebettetem Feldsteuertrichter
- 25': (verlorenes) gekürztes Feldsteuerelement für Spleißende
- 26: integrierter Feldsteuertrichter im Feldsteuerelement
- 26': Grundkörper eines Feldsteuerelements
- 28: einstückiges Feldsteuerelement mit zwei eingebetteten Feldsteuertrichtern 26
- 23P 25P 24'P 25'P 28P: Parkpositionen der zugehörigen Feldsteuertrichter oder Feldsteuerelemente
- 36: Masse-Potential
- 40: Kontakt (Hochspannungspotential)

## Patentansprüche

1. Prüfverfahren zur Messung von Teilentladungen an einem Spleiß von einadrigen Seekabeln für Mittel- und Hochspannung mit folgenden auf beiden im Spleiß zusammengefügten Kabelenden vorzunehmenden Verfahrensschritten:
- Herstellen einer für die Höhe der Prüfspannung durchschlagsicheren, leitschichtfreien Isolierstrecke (13) an den Kabelenden (6), wobei im Bereich des Spleiß' (8,20) auf der Kabelisolierung (21) eine äußere Leitschicht (22) vorhanden ist,
- Übergänge zwischen Isolierstrecke (13) und äußerer Leitschicht (10) am Kabelende (6) mit einem leitfähigen Feldsteuertrichter (23) als Einzelkörper und Übergänge zwischen Isolierstrecke (13) und mit äußerer Leitschicht (22) versehenem Kabelspleiß (20) mit einem Feldsteuerelement (25) mit integriertem Feldsteuertrichter (26) versehen,
- den am Kabelende (6) vorliegenden Feldsteuertrichter (23) und den Kabelleiter (7) in Kontakt zu Massepotential (36) bringen;
- auf äußerer Leitschicht des Kabelspleiß' (20) Hochspannungspotential anlegen;
- Teilentladungsmessung ausführen.

2. Prüfverfahren zur Messung von Teilentladungen an einem Spleiß von einadrigen Seekabeln für Mittel- und Hochspannung mit folgenden auf beiden im Spleiß zusammengefügten Kabelenden vorzunehmenden Verfahrensschritten:
- Herstellen einer für die Höhe der Prüfspannung durchschlagsicheren, leitschichtfreien Isolierstrecke (13) an den Kabelenden (6), wobei im Bereich des Spleiß' (8,20) auf der Kabelisolierung (21) eine äußere Leitschicht (22) vorhanden ist,
- die gesamte Isolierstrecke (13'") einschließlich der Übergänge zwischen Isolierstrecke (13'") und Leitschicht (10) am Kabelende (6) und der Übergänge zwischen Isolierstrecke (13'") und mit äußerer Leitschicht (22) versehenem Kabelspleiß (20) mit einem die Isolierstrecke (13"') bedeckenden Feldsteuerelement (28) mit eingebetteten leitfähigen Feldsteuertrichtern (26) versehen,
- Feldsteuertrichter (26) am Kabelende (6) und Kabelleiter (7) in Kontakt zu Massepotential (36) bringen;
- auf äußerer Leitschicht (22) des Kabelspleiß' (20) Hochspannungspotential anlegen;
- Teilentladungsmessung ausführen.

3. Prüfverfahren nach einem der Ansprüche 1 oder 2, **dadurch gekennzeichnet, dass** vor Herstellung des Kabelspleiß' (20) das oder die eingesetzten Feldsteuerelemente (23, 24', 25', 28) in eine Park-Position (23P, 24'P, 25'P, 28P) auf dem Kabelenede gebracht werden, und
- die Isolierung (21) auf dem Kabelspleiß (20) aufgebracht und mit äußerer Leitschicht (22) versehen werden;
- eine durchschlagsichere, leitschichtfreie Isolierstrecke (13, 13"') zwischen Kabelspleiß (20) und Kabelende (6) hergestellt wird;
- Feldsteuerelement(e) (23, 24', 25', 28) aus ihren Parkpositionen (23P, 24'P, 25'P, 28P) in Endlage am Kabelspleiß (20) schieben;
- auf äußerer Leitschicht (22) des Kabelspleiß' (20) Hochspannungspotential anlegen;
- Teilentladungsmessung ausführen.

4. Anordnung zur Potentialsteuerung bei der Durchführung eines Prüfverfahrens nach Anspruch 1, **dadurch gekennzeichnet, dass** die Übergänge zwischen Isolierstrecke (13) und Leitschicht (10) am Kabelende (6) mit einem leitfähigen Feldsteuertrichter (23) als Einzelkörper versehen sind und die Übergänge zwischen Isolierstrecke (13) und mit äußerer Leitschicht (22) versehenem Kabelspleiß (8,20) mit einem Feldsteuerelement (28) mit integrierten Feldsteuertrichter (26) versehen sind.

5. Anordnung zur Potentialsteuerung bei der Durchführung eines Prüfverfahrens nach Anspruch 2, **dadurch gekennzeichnet, dass** die gesamte Isolierstrecke (13"') von einem einstückigen Feldsteuerelement (28) mit eingebetteten Feldsteuertrichtern (26) bedeckt ist, wobei die eingebetteten Feldsteuertrichter (26) jeweils für die Potentialsteuerung am Kabelende (6) und für die Potentialsteuerung am Übergang zwischen Kabelspleiß (8,20) und Kabelende (6) ausgerichtet sind.

## Claims

1. Test method for measuring partial discharges at a splice of single-core submarine cables for medium and high voltage having the following method steps that are to be undertaken on both cable ends joined in the splice:
- producing an insulating clearance (13), which is secure against breakthrough for the magnitude of the test voltage and that has no screens, at the cable ends (6), wherein an outer screen (22) is present on the cable insulation (21) in the region of the splice (8, 20),
- providing transitions between the insulating clearance (13) and the outer screen (10) at the cable end (6) with a conductive field control funnel (23) as individual body and transitions between the insulating clearance (13) and the cable splice (20) provided with the outer screen (22) with a field control element (25) having an integrated field control funnel (26),
- bringing the field control funnel (23) present at the cable end (6) and the cable conductor (7) into contact with earth potential (36);
- applying a high-voltage potential to the outer screen of the cable splice (20);
- performing partial discharge measurement.

2. Test method for measuring partial discharges at a splice of single-core submarine cables for medium and high voltage having the following method steps that are to be undertaken on both cable ends joined in the splice:
- producing an insulating clearance (13), which is secure against breakthrough for the magnitude of the test voltage and that has no screens, at the cable ends (6), wherein an outer screen (22) is present on the cable insulation (21) in the region of the splice (8, 20),
- providing the entire insulating clearance (13"') including the transitions between the insulating clearance (13"') and the screen (10) at the cable end (6) and the transitions between the insulating clearance (13'") and the cable splice (20) provided with the outer screen (22) with a field control element (28) that covers the insulating clearnace (13'") and comprises embedded conductive field control funnels (26),
- bringing field control funnels (26) at the cable end (6) and cable conductors (7) into contact with earth potential (36);
- applying a high-voltage potential to the outer screen (22) of the cable splice (20);
- performing partial discharge measurement.

3. Test method according to either of Claims 1 and 2, **characterized in that**, before the production of the cable splice (20), the field control element or elements (23, 24', 25', 28) used are brought into a park position (23P, 24'P, 25'P, 28P) on the cable end, and
- the insulation (21) are applied to the cable splice (20) and provided with the outer screen (22);
- an insulating clearance (13, 13'"), which is secure against breakthrough and that has no screens, is produced between the cable splice (20) and the cable end (6);
- sliding the field control element(s) (23, 24', 25', 28) from their park positions (23P, 24'P, 25'P, 28P) to the end position on the cable splice (20);
- applying a high-voltage potential to the outer screen (22) of the cable splice (20);
- performing partial discharge measurement.

4. Arrangement for potential control when carrying out a test method according to Claim 1, **characterized in that** the transitions between the insulating clearance (13) and the screen (10) at the cable end (6) are provided with a conductive field control funnel (23) as individual body and the transitions between the insulating clearance (13) and the cable splice (8, 20) provided with the outer screen (22) are provided with a field control element (28) comprising integrated field control funnels (26).

5. Arrangement for potential control when carrying out a test method according to Claim 2, **characterized in that** the entire insulating clearance (13"') is covered by a single-part field control element (28) comprising embedded field control funnels (26), wherein the embedded field control funnels (26) are each oriented for the potential control at the cable end (6) and for the potential control at the transition between the cable splice (8, 20) and the cable end (6).

## Revendications

1. Procédé de contrôle destiné à mesurer des décharges partielles sur une épissure de câbles sous-marins à un conducteur pour moyenne et haute tension, comprenant les opérations suivantes à effectuer sur les deux extrémités de câble réunies dans l'épissure:
- former sur les extrémités de câble (6) une section isolante (13) sans écran, protégée contre le claquage pour le niveau de la tension de contrôle, dans lequel il se trouve un écran extérieure (22) dans la région de l'épissure (8, 20) sur l'isolant du câble (21),
- munir des transitions entre la section isolante (13) et l'écran extérieure (10) sur l'extrémité de câble (6) d'un entonnoir de commande de champ conducteur (23) comme corps individuel et des transitions entre la section isolante (13) et l'épissure de câble (20) munie de l'écran extérieure (22) d'un élément de commande de champ (25) avec un entonnoir de commande de champ intégré (26),
- mettre l'entonnoir de commande de champ (23) présent sur l'extrémité de câble (6) et le conducteur de câble (7) en contact avec le potentiel de masse (36),
- appliquer un potentiel de haute tension à l'écran extérieure de l'épissure de câble (20),
- effectuer la mesure de décharges partielles.

2. Procédé de contrôle destiné à mesurer des décharges partielles sur une épissure de câbles sous-marins à un conducteur pour moyenne et haute tension, comprenant les opérations suivantes à effectuer sur les deux extrémités de câble réunies dans l'épissure:
- former sur les extrémités de câble (6) une section isolante (13) sans écran, protégée contre le claquage pour le niveau de la tension de contrôle, dans lequel il se trouve un écran extérieure (22) dans la région de l'épissure (8, 20) sur l'isolant du câble (21),
- munir toute la section isolante (13"'), y compris les transitions entre la section isolante (13"') et l'écran (10) sur l'extrémité de câble (6) et les transitions entre la section isolante (13"') et l'épissure de câble (20) munie de l'écran extérieure (22) d'un élément de commande de champ (28) recouvrant la section isolante (13"') avec des entonnoirs de commande de champ conducteurs noyés (26),
- mettre les entonnoirs de commande de champ (26) sur l'extrémité de câble (6) et le conducteur de câble (7) en contact avec le potentiel de masse (36);
- appliquer un potentiel de haute tension à l'écran extérieure (22) de l'épissure de câble (20);
- effectuer la mesure de décharges partielles.

3. Procédé de contrôle selon l'une des revendications 1 ou 2, **caractérisé en ce qu'**avant la formation de l'épissure de câble (20), on place le ou les élément(s) de commande de champ utilisé(s) (23, 24', 25', 28) dans une position de rangement (23P, 24'P, 25'P, 28P) sur l'extrémité de câble, et
- on pose l'isolant (21) sur l'épissure de câble (20) et on le munit de l'écran extérieure (22);
- on forme une section isolante (13, 13"') sans écran, protégée contre le claquage, entre l'épissure de câble (20) et l'extrémité de câble (6);
- on glisse des éléments de commande de champ (23, 24', 25', 28) hors de leur position de rangement (23P, 24'P, 25'P, 28P) en position finale sur l'épissure de câble (20);
- on applique un potentiel de haute tension à l'écran extérieure (22) de l'épissure de câble (20);
- on effectue la mesure de décharges partielles.

4. Dispositif pour la commande du potentiel lors de l'exécution d'un procédé de contrôle selon la revendication 1, **caractérisé en ce que** les transitions entre la section isolante (13) et l'écran (10) sur l'extrémité de câble (6) sont munies d'un entonnoir de commande de champ conducteur (23) comme corps individuel et les transitions entre la section isolante (13) et l'épissure de câble (8, 20) munie d'un écran extérieure (22) sont munies d'un élément de commande de champ (28) avec un entonnoir de commande de champ intégré (26).

5. Dispositif pour la commande du potentiel lors de l'exécution d'un procédé de contrôle selon la revendication 2, **caractérisé en ce que** toute la section isolante (13"') est recouverte d'un élément de commande de champ en une seule pièce (28) avec des entonnoirs de commande de champ noyés (26), dans lequel les entonnoirs de commande de champ noyés (26) sont orientés respectivement pour la commande du potentiel à l'extrémité de câble (6) et pour la commande du potentiel à la transition entre l'épissure de câble (8, 20) et l'extrémité de câble (6).
